# EUROPEAN PATENT SPECIFICATION

(11) **EP 2 685 541 B1**
(45) Date of publication and mention of the grant of the patent: **08.06.2016**
(21) Application number: 13176291.6
(22) Date of filing: 12.07.2013
(51) Int. Cl.: H01M 10/42, H01M 10/48, H01M 2/02, G01R 31/36, H02J 7/00

(54) **Devices, systems, and methods for battery cell fault detection**
Vorrichtungen, Systeme und Verfahren zur Batteriezellenfehlererkennung
Dispositifs, systèmes et procédés de détection de défaut de cellule de batterie

(30) Priority: 12.07.2012 US 201261670723 P; 27.06.2013 US 201313928963
(43) Date of publication of application: 15.01.2014
(73) Proprietor: Covidien LP, Mansfield, MA 02048 (US)
(72) Inventor: Lopez, John T., Boulder, CO Colorado 80301 (US)
(74) Representative: Soames, Candida Jane

(56) References cited:
- WO-A1-2011/040446
- WO-A1-2012/166310
- KR-A- 20050 036 633
- US-A1- 2012 148 888
- US-A1- 2012 299 555

## Description

### BACKGROUND

### Technical Field

The present disclosure relates to battery cell monitoring and, more particularly, to devices, systems, and methods for detecting fault conditions at the battery cell level.

### Background of Related Art

Battery-powered devices are advantageous in that they obviate the need for cables coupling the device to an electrical outlet or external power source. A typical battery pack for a battery-powered device includes one or more battery cells coupled to one another via a powering circuit that provides electrical power to the device.

Battery packs have been developed that include control and safety circuitry configured to monitor various characteristics of the battery cells, both collectively and individually, e.g., individual battery cell voltage, battery pack voltage, temperature, and/or current, such that conditions that may cause failure or damage to the individual battery cells, the battery pack, and/or the device, e.g., as a result of overvoltage, under-voltage, over-temperature, or over-current, may be averted.

Control and safety circuitry is also utilized to detect battery cell failure, for example, by detecting excessive internal self-discharge, atypical impedance, or state of charge curve anomalies. However, in some instances, the control and safety circuitry may be unable to detect battery cell fault conditions at an early stage, e.g., before failure occurs.

US 2012/0186071 discloses a method for manufacturing an electrochemical cell, wherein an insulation failure product can be accurately rejected, and an electrochemical cell can be used again after the insulation failure inspection in the method for manufacturing the electrochemical cell, which is configured by hermetically housing an electrochemical cell main body such that the leading end of a metal terminal and a metal foil layer, the waveform of the voltage applied to the capacitance between the metal terminal and the metal foil layer is measured, and the insulation failure inspection step is performed.

### SUMMARY

The systems and methods according to aspects of the present disclosure provide early detection of pre-failure fault conditions at the battery cell level so that battery cell failure and battery pack failure can be averted.

In accordance with aspects of the present disclosure, a battery assembly is provided generally including a battery cell, a pouch, and a conductive lead. The pouch encloses the battery cell and includes an inner insulative jacket, an outer insulative jacket, and a conductive foil disposed between the inner and outer insulative jackets. The conductive lead extends through the outer insulative jacket and is electrically coupled to the conductive foil. The conductive lead is configured to electrically couple to battery circuitry for monitoring a voltage on the conductive foil to determine a fault condition.

The battery assembly further includes a pair of electrode terminals coupled to the battery cell and extending from the pouch.

The battery circuitry is coupled to the electrode terminals and is configured to monitor characteristics of the battery cell and to regulate charging and discharging of the battery cell based on the monitored characteristics of the battery cell.

In aspects, the battery circuitry includes an analog to digital converter that is electrically coupled to the conductive lead and is configured to convert an analog voltage on the conductive lead into a digital voltage value. The battery circuit may further include a microcontroller, which preferably provides the analog to digital converter, having a central processing unit configured to evaluate the digital value for determining the fault condition.

In aspects, the battery circuit may include logic circuitry configured to determine whether a fault condition exists based on the voltage of the conductive lead. The logic circuitry may include a comparator that is configured to receive a voltage corresponding with the voltage of the conductive lead. The voltage may be the output from an analog to digital converter or may be analog values fed directly from the conductive lead. The comparator compares the voltage with a predetermined reference voltage value which may be zero or non-zero.

In aspects, the battery cell is a lithium polymer battery cell.

In aspects, the battery circuitry includes measurement circuitry configured to measure the voltage on the conductive foil and logic circuitry configured to determine whether the fault condition exits by comparing the voltage on the conductive foil to a predetermined voltage value. The predetermined voltage value may correspond to a zero voltage. Alternatively, the predetermined voltage value may correspond to a non-zero voltage threshold.

In aspects, the pouch is heat sealed about the battery cell.

A method of monitoring fault conditions in the battery cell assembly is also provided in accordance with aspects the present disclosure. The method includes measurement circuitry of the battery circuitry determining a voltage on the conductive foil, logic circuitry of the battery circuitry comparing the voltage on the conductive foil to a predetermined voltage value and, if the voltage on the conductive foil exceeds the predetermined voltage value, indicating a fault condition. The method comprises the battery circuitry monitoring characteristics of the battery cell and the battery circuitry regulating charging and discharging of the battery cell based on the monitored characteristics of the battery cell.

In aspects, the method further includes converting the voltage on the conductive foil to a digital voltage value corresponding to the voltage on the conductive foil.

The predetermined voltage value may correspond to zero volts. Alternatively, the predetermined voltage value may correspond to a non-zero voltage.

A battery assembly provided in accordance with aspects of the present disclosure includes a battery pack having a plurality of battery cells assemblies. Each battery cell assembly includes a battery cell and a pouch enclosing the battery cell. The pouch includes an inner insulative jacket, an outer insulative jacket, and a conductive foil disposed between the inner and outer insulative jackets. A conductive lead extends through the outer insulative jacket and is electrically coupled to the conductive foil. The battery assembly further includes battery circuitry including measurement circuitry electrically coupled to the conductive lead of each of the plurality of battery cell assemblies to measure a voltage of the conductive foil, and logic circuitry coupled to the measurement circuitry and configured to determine whether a fault condition exits based on the measured voltage of the conductive foil of each of the plurality of battery cell assemblies. The battery circuitry is coupled to electrode terminals of each of the battery cell assemblies. The battery circuitry is configured to monitor characteristics of the respective battery cells and to regulate charging and discharging of the battery cells based on the monitored characteristics.

In aspects, the logic circuitry determined whether a fault condition exists by comparing the measured voltage of each of the plurality of battery cell assemblies to a predetermined voltage.

In aspects, the battery cell of one or more of the battery cell assemblies is a lithium polymer battery cell.

The predetermined voltage value may correspond to zero volts or may correspond to a non-zero voltage threshold.

In aspects, a plurality of analog to digital converters are provided. Each analog to digital converter is electrically coupled to one of the conductive leads and is configured to convert an analog voltage value from the conductive lead into a digital voltage value for output to the logic circuitry.

In aspects, a multiplexer is coupled to each of the conductive leads and is configured to alternatingly provide an analog voltage of each of the conductive leads. An analog to digital converter is configured to alternatingly receive the analog voltage of each battery cell assembly from the multiplexer and to convert the analog voltage into a digital voltage value for output to the logic circuitry.

In aspects, the battery circuitry includes a microcontroller that provides one or more analog to digital converters and a central processing unit. Each conductive lead of each battery cell assembly may be coupled to an analog to digital converter for outputting digital values corresponding to the analog voltages to the central processing unit. Alternatively, each conductive lead of each battery cell assembly may be coupled to a multiplexer that is coupled to an analog to digital converter for outputting digital values corresponding to the analog voltages to the central processing unit. The central processing unit is configured to evaluate the digital voltage values to determine whether or not a fault condition exists in any of the battery cell assemblies.

A surgical instrument provided in accordance with aspects of the present disclosure includes an electrosurgical instrument having a housing configured to engage with a battery assembly in accordance with the aforementioned aspects. Preferably, the engagement is releasable. A shaft may be coupled to the housing at a proximal end thereof. An end effector including jaw members may be disposed at a distal end of the shaft. A generator may be provided that is preferably releasably engageable with a body portion of the housing and is preferably selectively removable from the body portion either in connection with the removal of the battery assembly or independently.

In aspects, the generator is disposed in operable communication with the battery assembly to provide electrosurgical energy to the end effector for electrosurgically treating tissue.

In aspects, one of the jaw members serves as an active or oscillating ultrasonic blade that is selectively activatable to ultrasonically treat tissue grasped between the jaw members. The generator may convert electrical energy provided by the battery assembly into a high voltage AC waveform that drives a transducer configured to convert electrical energy into mechanical energy that produces motion at the blade.

In the aforementioned aspects, the battery circuitry may be configured to disconnect faulted battery cell(s) and/or surrounding battery cell(s) from the remainder of the system and/or may be configured to disconnect all battery cell(s).

### BRIEF DESCRIPTION OF THE DRAWINGS

Various aspects of the present disclosure are described hereinbelow with reference to the drawings, wherein:
Fig. 1 is a side, perspective view of a portable, battery-powered surgical instrument configured for use in accordance with some embodiments of the present disclosure;
Fig. 2 is a side, perspective view of another portable, battery-powered surgical instrument configured for use in accordance with other embodiments of the present disclosure;
Fig. 3 is a side, perspective view of a battery assembly provided in accordance with the present disclosure and configured for use with the instruments of Figs. 1 and 2;
Fig. 4 is an exploded, perspective view of the battery assembly of Fig. 3;
Fig. 5 is a front, cross-sectional view of one of the battery cells of the battery assembly of Fig. 3;
Fig. 6 is an enlarged view of the area of detail indicated as "6" in Fig. 5;
Fig. 7 is a cross-sectional view of opposed ends of adjacent battery cells of the battery assembly of Fig. 3;
Fig. 8A is a schematic diagram showing one configuration for monitoring the battery cells of the battery assembly of Fig. 3;
Fig. 8B is a schematic diagram showing another configuration for monitoring the battery cells of the battery assembly of Fig. 3; and
Fig. 8C is a schematic diagram showing another configuration for monitoring the battery cells of the battery assembly of Fig. 3.

### DETAILED DESCRIPTION

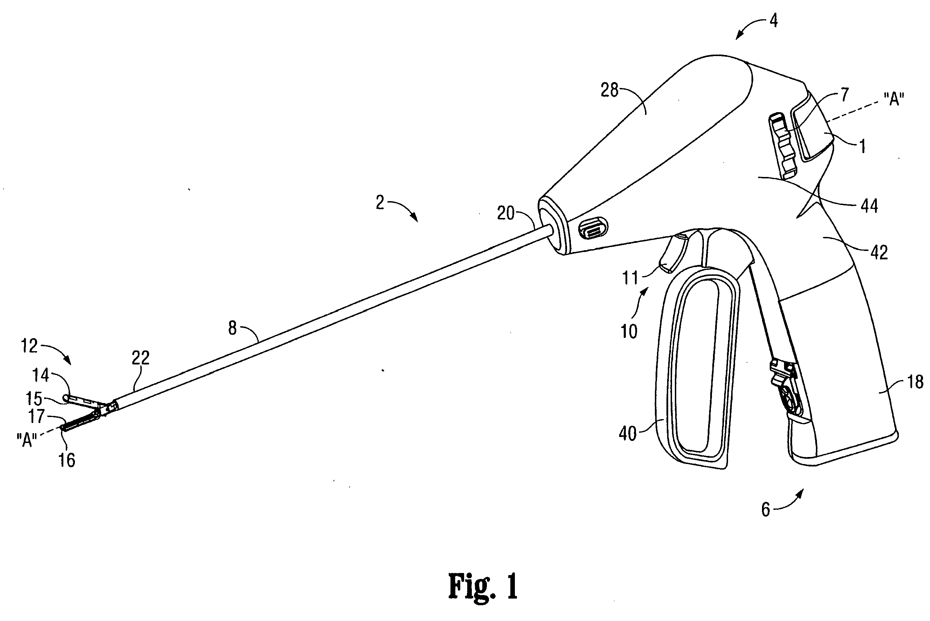

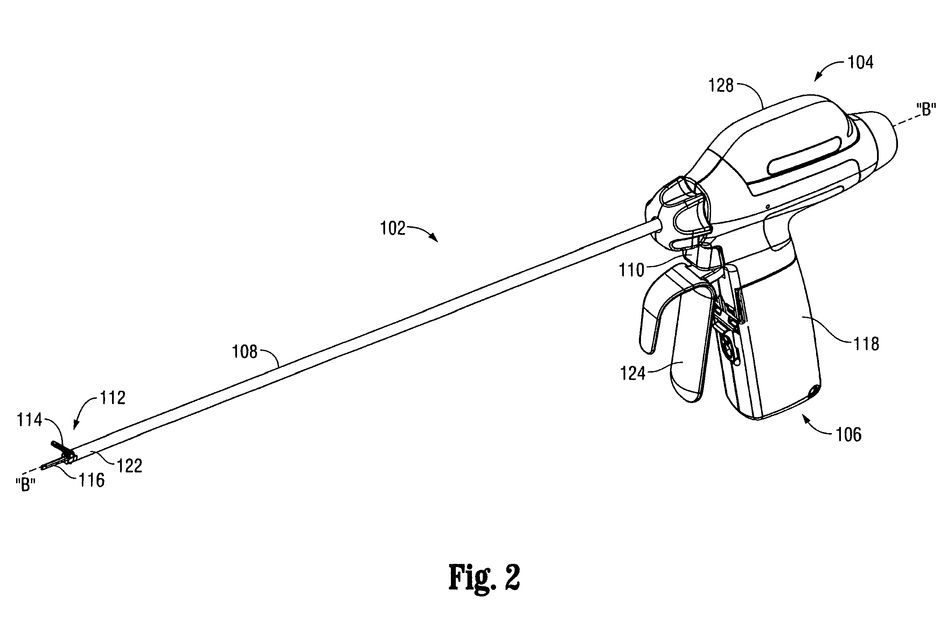

Referring now to Figs. 1 and 2, Fig. 1 depicts a portable, battery-powered electrosurgical instrument 2 and Fig. 2 depicts a portable, battery-powered ultrasonic surgical instrument 102. For the purposes herein, either an electrosurgical instrument, e.g., instrument 2, an ultrasonic instrument, e.g., instrument 102, or any other suitable battery-powered device, e.g., a surgical instrument, handheld tool, electronic device, or the like, may be utilized in accordance with the present disclosure. Obviously, different considerations apply to each particular type of device; however, the features and aspects of the present disclosure are equally applicable and remain generally consistent with respect to any suitable battery-powered device. For the purposes herein, electrosurgical instrument 2 and ultrasonic instrument 102 are generally described.

With reference to Fig. 1, electrosurgical instrument 2, shown as an electrosurgical forceps, generally includes a housing 4, a battery assembly 18, an electrosurgical generator 28, a handle assembly 6, a rotating assembly 7, a shaft 8, a trigger assembly 10, a drive assembly (not shown), and an end effector assembly 12. End effector assembly 12 operatively connects to handle assembly 6 via the drive assembly (not shown) for imparting movement of one or both of jaw members 14, 16 of end effector assembly 12 between a spaced-apart position and an approximated position for grasping tissue therebetween.

Continuing with reference to Fig. 1, shaft 8 is coupled to housing 4 at proximal end 20 thereof and extends distally from housing 4 to define a longitudinal axis "A-A." End effector assembly 12, including jaw members 14 and 16, is disposed at a distal end 22 of shaft 8. End effector assembly 12 is shown configured as a unilateral assembly wherein jaw member 16 is fixed relative to shaft 8 and jaw member 14 is pivotable relative to jaw member 16 and shaft 8 between the spaced-apart and approximated positions. However, this configuration may be reversed, e.g., wherein jaw member 14 is fixed relative to shaft 8 and jaw member 16 is pivotable relative to jaw member 14 and shaft 8. Alternatively, end effector assembly 12 may be configured as a bilateral assembly, e.g., wherein both jaw members 14, 16 are pivotable relative to one another and shaft 8 between the spaced-apart and approximated positions.

Electrosurgical instrument 2 may be configured as a bipolar instrument. That is, each of the jaw members 14, 16 may include a respective seal plate 15, 17 that is configured to function as an active (or activatable) and/or return electrode. Each seal plate 15, 17 is electrically coupled to generator 28 via one or more electrical leads (not shown) that extend from generator 28, through shaft 8, and eventually coupling to one or both of seal plates 15, 17 for conducting energy through tissue grasped therebetween. However, forceps 2 may alternatively be configured as a monopolar instrument.

Handle assembly 6 includes a moveable handle 40 that is movable relative to fixed handle portion 42 for moving jaw members 14, 16 of end effector assembly 12 between the spaced-apart and approximated positions. Rotating assembly 7 is rotatable in either direction about longitudinal axis "A-A" to rotate shaft 8 and, thus, end effector assembly 12 about longitudinal axis "A-A." Trigger assembly 10 is in operable communication with a knife assembly (not shown) including a knife blade (not shown) that is selectively translatable between jaw members 14, 16 to cut tissue grasped therebetween, e.g., upon actuation of trigger 11 of trigger assembly 10.

With continued reference to Fig. 1, housing 4 is configured to releasably engage electrosurgical generator 28 and battery assembly 18. Generator 28 is releasably engagable with body portion 44 of housing 4, while battery assembly 18 is releasably engagable with fixed handle portion 42 of housing 4. More specifically, battery assembly 18 is configured to engage fixed handle portion 42 of housing 4 such that battery assembly 18 functions as the stationary handle of housing 4 to facilitate grasping of the forceps 2. Generator 28 releasably engages body portion 44 of housing 4 and may be selectively removable from body portion 44 either in connection with the removal of battery assembly 18 or independently.

When forceps 2 is assembled, generator 28 is disposed in operable communication with battery assembly 18 to provide electrosurgical energy to end effector 12 for electrosurgically treating tissue, e.g., to seal tissue, although forceps 2 may alternatively be configured to deliver any other suitable form of energy to tissue, e.g., thermal energy, microwave energy, light energy, etc. With respect to electrosurgical tissue treatment, generator 28 may include suitable electronics that convert the electrical energy from battery assembly 18 into an RF energy waveform to energize one or both of jaw members 14, 16. That is, generator 28 may be configured to transmit RF energy to seal plate 15 of jaw member 14 and/or seal plate 17 of jaw member 16 to conduct energy therebetween for treating tissue. Activation switch 1 disposed on housing 4 is activatable for selectively enabling generator 28 to generate and subsequently transmit RF energy to seal plate 15 and/or seal plate 17 of jaw members 14, 16, respectively, for treating tissue grasped therebetween.

Referring now to Fig. 2, ultrasonic instrument 102 includes components similar to that of forceps 2 shown in Fig. 1, namely, a housing 104, a battery assembly 118, a generator 128, a handle assembly 106, a shaft 108, and an end effector assembly 112. Accordingly, only the difference between ultrasonic instrument 102 and forceps 2 (Fig. 1) will be described below.

Housing 104 is configured to releasably engage ultrasonic generator 128 and battery assembly 118. Shaft 108 extends distally from housing 104 to define longitudinal axis "B-B" and includes end effector assembly 112 disposed at distal end 122 thereof. One or both of jaw members 114 and 116 of end effector assembly 112 are movable relative to one another, e.g., upon actuation of moveable handle 124, between an open position and a clamping position for grasping tissue therebetween. Further, one of the jaw members, e.g., jaw member 116, serves as an active or oscillating ultrasonic blade that is selectively activatable to ultrasonically treat tissue grasped between jaw members 114, 116.

Generator 128 includes a transducer (not shown) configured to convert electrical energy provided by battery assembly 118 into mechanical energy that produces motion at the end of a waveguide, e.g., at blade 116. More specifically, the electronics (not explicitly shown) of the generator 128 convert the electrical energy provided by battery assembly 118 into a high voltage AC waveform that drives the transducer (not shown). When the transducer (not shown) and the waveguide are driven at their resonant frequency, mechanical, e.g., ultrasonic, motion is produced at the active jaw member 116 for treating tissue grasped between jaw members 114, 116. Further, an activation button 110 disposed on housing 104 is selectively activatable to operate instrument 102 in two modes of operation: a low-power mode of operation and a high-power mode of operation.

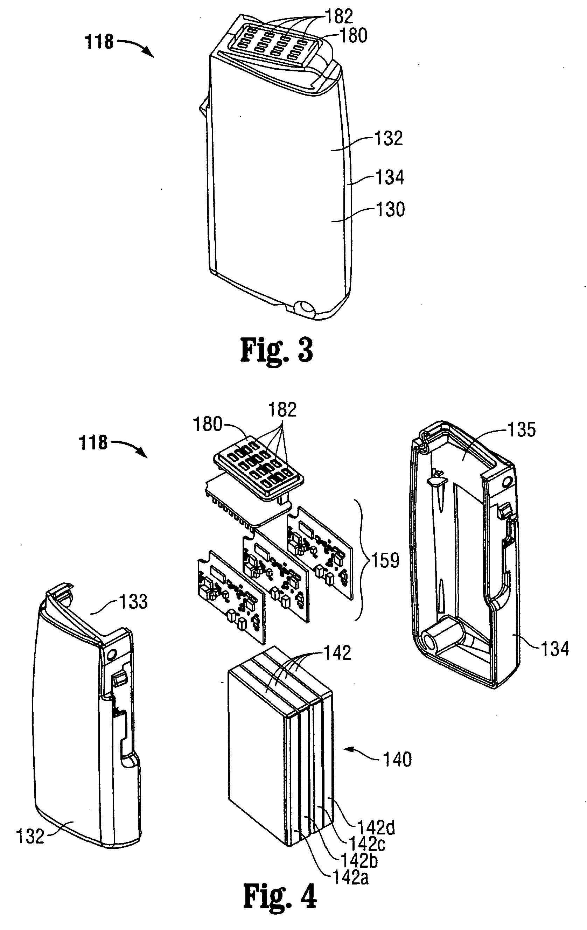

Referring to Figs. 3-8C, features and aspects of the present disclosure are described with respect to exemplary battery assembly 118, which is shown and described for purposes of simplicity and consistency as being configured for use with ultrasonic instrument 102 (Fig. 2). However, as mentioned above, the features and aspects of the present disclosure are equally applicable for use with battery assembly 18 (Fig. 1) of forceps 2 (Fig. 1), or any other suitable battery assembly configured for use with a battery-powered device.

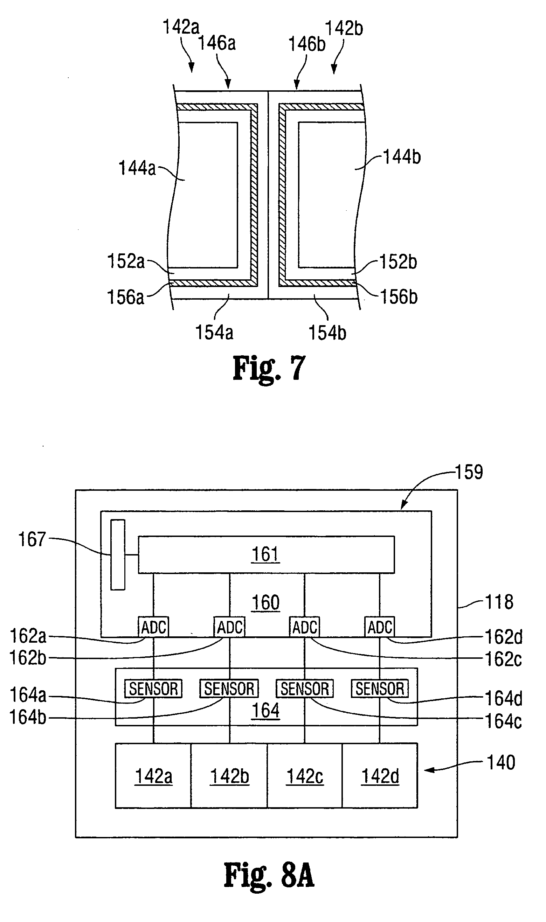

With reference to Figs. 3-4, battery assembly 118 generally includes an outer housing 130, a battery pack 140, battery circuitry 159, and a contact cap 180. Battery circuitry 159, as shown in Fig. 8A, includes measurement circuitry 164 and a microcontroller 160 having a central processing unit 161 and memory 167, e.g., ROM, RAM, or other suitable memory. Outer housing 130 is formed from first and second housing parts 132, 134 that cooperate to house battery pack 140 and battery circuitry 159. Housing parts 132, 134 define cut-outs 133, 135, respectively, that cooperate to form a window configured to retain contact cap 180.

Contact cap 180 is electrically coupled to battery circuitry 159, which, in turn, is electrically coupled to battery pack 140. Contact cap 180 includes a plurality of contacts 182 configured to provide an electrical interface between battery assembly 118, e.g., battery pack 140 and battery circuitry 159, and the battery-powered device, e.g., ultrasonic instrument 102 (Fig. 2), for transmitting power and/or control signals therebetween.

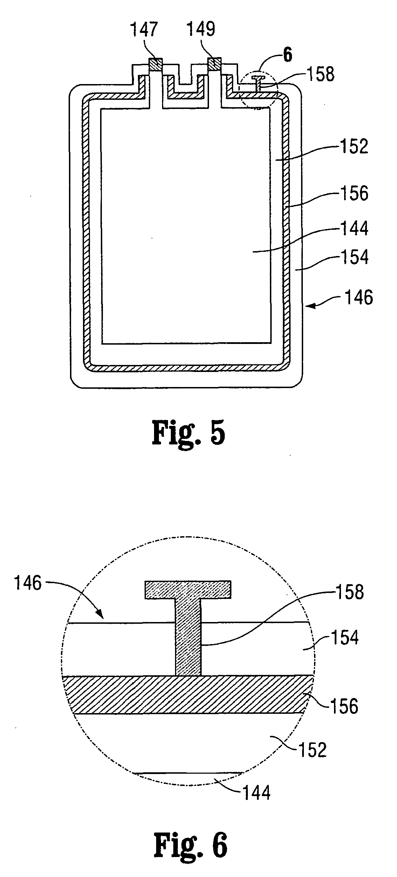

Referring additionally to Figs. 5 and 6, battery pack 140 includes a plurality of battery cell assemblies 142a, 142b, 142c, 142d (collectively battery cell assemblies 142), e.g., four (4) battery cell assemblies 142, although greater or fewer battery cell assemblies 142 are also contemplated. Each battery cell assembly 142 includes a battery cell 144, e.g., a lithium polymer battery cell or other suitable battery cell, a pouch 146 surrounding the battery cell 144 and configured to seal the battery cell 144 within the pouch 146, and a pair of electrode terminals 147, 149, e.g., a positive electrode terminal 147 and a negative electrode terminal 149, extending from the battery cell 144 through the pouch 146 to facilitate charging and discharging of the battery cell 144.

More specifically, electrode terminals 147, 149 are coupled to battery circuitry 159 such that battery circuitry 159 can monitor each battery cell 144 and/or the battery pack 140 as a whole, e.g., such that microcontroller 160 can monitor individual battery cell voltage, battery pack voltage, temperature, current, charge and discharge rates, impedance, etc., and are ultimately coupled to one or more of contacts 182 for providing power to ultrasonic instrument 102 (Fig. 2) and/or receiving power from a battery charging device (not shown).

Continuing with reference to Figs. 5 and 6, pouch 146 may be configured as a metalized plastic polymer pouch that is heat sealed about the battery cell 144, although other suitable configurations are also contemplated. More specifically, pouch 146 includes an inner insulative jacket 152, an outer insulative jacket 154, and a conductive or metal foil 156 sandwiched between the inner and outer insulative jackets 152, 154, respectively, and electrically insulated from battery cell 144. Foil 156 provides a protective barrier that inhibits electrolyte leakage from the battery cell 144 through pouch 146.

A conductive lead 158 extends through outer insulative jacket 154 and is electrically coupled, e.g., soldered, to foil 156 without penetrating inner insulative jacket 152. The free end of conductive lead 158 is electrically coupled to measurement circuitry 164 which, in turn, is coupled to microcontroller 160 (see Fig. 8A). As will be described below, this configuration allows microcontroller 160 to monitor the presence of a voltage on conductive foil 156. The conductive lead 158 may be any suitable electrical conductor, e.g., a wire, of any suitable physical shape or size for electrically coupling conductive foil 156 to measurement circuitry 164.

With reference to Figs. 4 and 7, battery cell assemblies 142a, 142b, 142c, 142d are positioned in a side-by-side abutting relation relative to one another. Thus, as shown in Fig. 7, adjacent battery cell assemblies 142a, 142b are positioned such that the outer insulative jackets 154a, 154b of battery cell assemblies 142a, 142b, respectively, abut one another. This configuration protects and insulates each battery cell assembly 142a, 142b from the other.

However, in instances where this protection fails, short circuiting between adjacent battery cell assemblies 142a, 142b, respectively, may occur. Such a failure is considered a double-failure because adjacent battery cell assemblies 142a, 142b experience electrolyte leakage through respective inner insulative jackets 152a, 152b, which results in charging of respective conductive foils 156a, 156b, and further leakage from battery cell assemblies 142a, 142b through respective outer insulative jackets 154a, 154b electrically couples battery cell assemblies 142a, 142b to one another, thereby establishing the short circuit.

As will be described below, the conductive leads 158 of each battery cell assembly 142, the measurement circuitry 164 of battery circuitry 159, and the microcontroller 160 of battery circuitry 159, cooperate to provide for the monitoring of the foil 156 of each battery cell assembly 142 to determine whether there is a predetermined voltage on the foil 156, thus indicating the presence of a fault condition, e.g., electrolyte leakage, before the fault condition escalates into a failure resulting in a short circuit between adjacent battery cell assemblies 142 or other undesired condition.

Turning now to Figs. 8A-8C, in conjunction with Figs. 3-7, as mentioned above, the electrode terminals 147, 149, of each battery cell assembly 142a, 142b, 142c, 142d are coupled to microcontroller 160 for regulating charge and discharge and of the battery cells 144 and monitoring characteristics of the battery cells 144, both individually and collectively.

Further, as also mentioned above, each battery cell assembly 142a, 142b, 142c, 142d includes a conductive lead 158 that is electrically coupled to the foil 156 of the respective battery cell assembly 142a, 142b, 142c, 142d. The conductive lead 158 of each battery cell assembly 142a, 142b, 142c, 142d is electrically coupled at its other end to measurement circuitry 164 of battery circuitry 159 and, ultimately, microcontroller 160 of battery circuitry 159 for monitoring the presence of a voltage on the respective foil 156. Exemplary configurations of such battery circuitry 159 configured for monitoring the presence of a voltage on foil 156 are described below with reference to Figs. 8A-8C, although other configurations are also contemplated.

As shown in Fig. 8A, in conjunction with Figs. 3-7, in one embodiment, the conductive lead 158 of each battery cell assembly 142a, 142b, 142c, 142d in the battery pack 140 of the battery assembly 118 is coupled to measurement circuitry 164. More specifically, the conductive lead 158 of each battery cell assembly 142a, 142b, 142c, 142d is coupled to a respective sensor 164a, 164b, 164c, 164d of measurement circuitry 164. Sensors 164a, 164b, 164c, 164d may include voltage dividers, or any other suitable sensors for sensing a voltage on foils 156. Alternatively or additionally, sensors 164a, 164b, 164c, 164d may be configured to sense current and/or any other electrical characteristic of conductive foils 156.

Each sensor 164a, 164b, 164c, 164d is coupled to an A/D converter 162a, 162b, 162c, 162d, respectively, of microcontroller 160. As such, the voltage on the foil 156 of each battery cell assembly 142a, 142b, 142c, 142d is input into and sensed by the respective sensor 164a, 164b, 164c, 164d of the measurement circuitry 164 and the sensed voltage is output to the respective A/D converter 162a, 162b, 162c, 162d. A digital voltage value corresponding to the sensed analog voltage provided by sensors 164a, 164b, 164c, 164d and input to the respective A/D converter 162a, 162b, 162c, 162d is output to central processing unit 161 of microcontroller 160 (or other suitable logic circuitry), which is configured to evaluate the digital voltage value to determine whether or not a fault condition exists in any of the battery cell assemblies 142a, 142b, 142c, 142d. Any suitable logic circuitry associated with or separate from central processing unit 161 or microcontroller 160 may be provided for determining the presence of this fault condition. Central processing unit 161 may ultimately relay the determination of whether or not a fault condition is present on any or all of the battery cell assemblies 142a, 142b, 142c, 142d to a user interface (not shown) or may otherwise be configured to indicate the presence of a fault condition.

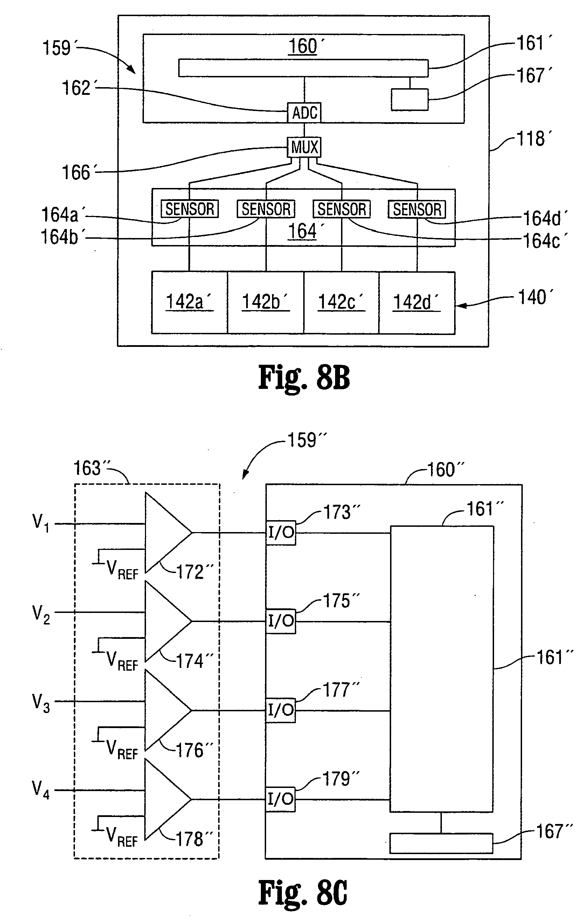

As shown in Fig. 8B, in conjunction with Figs. 3-7, in another embodiment, battery assembly 118' includes a battery pack 140' and battery circuitry 159' having measurement circuitry 164' and a microcontroller 160' having a central processing unit 161' and a memory 167', e.g., ROM, RAM, or other suitable memory. Each of the battery cell assemblies 142a', 142b', 142c', 142d' of the battery pack 140' is coupled to a sensor 164a', 164b', 164c', 164d' of measurement circuitry 164'. Sensors 164a', 164b', 164c', 164d', in turn, are coupled to a 4-to-1 multiplexer, or MUX 166' (although MUXs having a greater or smaller number of channels may be used, depending on the number of battery cells in the battery pack).

MUX 166' is coupled to an A/D converter 162' associated with microcontroller 160'. MUX 166' alternatingly relays the analog voltages read from the sensors 164a', 164b', 164c', 164d' that corresponds to the voltage on the foil 156 of respective battery cell assemblies 142a', 142b', 142c', 142d' to A/D converter 162', which outputs a digital voltage value corresponding to the sensed analog voltage to the central processing unit 161' of the microcontroller 160' (or other suitable logic circuitry). That is, rather than providing separate A/D converters 162a, 162b, 162c, 162d (Fig. 8A) for each battery cell assembly 142a, 142b, 142c, 142d (Fig. 8A) as in the embodiment of Fig. 8A, the MUX 166' allows for transmission sensed analog voltages from each sensor 164a', 164b', 164c', 164d' of the respective battery cell assemblies 142a', 142b', 142c', 142d' to a single A/D converter 162'. Similarly as above, the central processing unit 161' determines whether or not a fault condition exists and may indicate the presence of a fault condition in any suitable fashion. Battery assembly 118' may otherwise be configured similarly to battery assembly 118 (Fig. 8A).

Referring to Fig. 8C, in another embodiment, battery circuitry 159" includes a comparator bank 163", a microcontroller 160" having a central processing unit 161", and a memory 167", e.g., ROM, RAM, or other suitable memory. Comparator bank 163" includes comparators 172", 174", 176", 178" that are configured to receive respective voltage values V₁, V₂, V₃, V₄ corresponding to the voltage on the foil 156 (Figs. 5-7) of the respective battery cell assembly 142a, 142b, 142c, 142d (Fig. 4) output from the measurement circuitry, e.g., such as the measurement circuitry 164 of battery circuitry 159 (Fig. 8A), or other suitable measurement circuitry. The voltage values V₁, V₂, V₃, V₄ may be produced from respective A/D converters, e.g., A/D converters 162a, 162b, 162c, 162d (Fig. 8A), or may be analog values fed directly from the respective conductive lead 158 (Figs. 5-6). As an alternative to comparators 172", 174", 176", 178" and microcontroller 160", any other suitable logic circuitry may be provided. Further, other suitable circuitry, e.g., differential amplifiers, etc., may replace comparator bank 163".

Each comparator 172", 174", 176", 178" compares the voltage value V₁, V₂, V₃, and V₄ to a predetermined reference voltage value V_{REF}. The predetermined reference voltage value V_{REF} may correspond to a zero voltage or may correspond to a non-zero voltage threshold. In either configuration, the comparators 172", 174", 176", 178" determine whether the voltage values V₁, V₂, V₃, V₄ corresponding to the voltage on the foils 156 (Fig. 5-6) of the respective battery cell assemblies 142a, 142b, 142c, 142d (Fig. 4) exceeds the predetermined reference voltage value V_{REF} and output a corresponding signal for each battery cell assembly 142a, 142b, 142c, 142d (Fig. 4) to the respective I/O's 173", 175", 177", 179" of the microcontroller 160". The determination that the voltage on one or more of the foils 156 (Figs. 5-6) is greater than a predetermined reference voltage value V_{REF}, e.g., greater than zero volts or greater than a voltage threshold, indicates the presence of a fault condition.

Referring to Figs. 1-8C, in any of the above embodiments, in response to detection of a fault condition, the microcontroller 160, 160', 160" or component thereof, may be configured to activate an audible and/or visible alarm, e.g., activate a speaker (not shown) or one or more LEDs (not shown). The microcontroller 160, 160', 160" may additionally or alternatively be configured to disconnect the faulted battery cell(s) and/or surrounding battery cell(s) from the remainder of the system or may be configured to disconnect the entire battery pack, or otherwise render the system partially or wholly inoperable. Other suitable actions in response to detection of a fault condition are also contemplated. The particular action taken in response to determining the presence of a fault condition may depend on the particular battery pack used, the particular device used in conjunction with the battery pack, user preference, the severity of the fault, e.g., the voltage value detected, whether there is a single or multiple faults, etc., or other factors.

While several embodiments of the disclosure have been shown in the drawings, it is not intended that the disclosure be limited thereto, as it is intended that the disclosure be as broad in scope as the art will allow and that the specification be read likewise. Therefore, the above description should not be construed as limiting, but merely as exemplifications of particular embodiments. Those skilled in the art will envision other modifications within the scope of the claims appended hereto.

## Claims

1. A battery cell assembly (144) and battery circuitry (159), the battery cell assembly, comprising:
a battery cell;
a pouch (146) enclosing the battery cell, the pouch comprising:
an inner insulative jacket (152);
an outer insulative jacket (154); and
a conductive foil (156) disposed between the inner and outer insulative jackets;
a conductive lead (158) electrically coupled to the conductive foil and extending through the outer insulative jacket, the conductive lead configured to electrically couple to the battery circuitry, the battery circuitry for monitoring a voltage on the conductive foil to determine a fault condition,
the battery cell assembly further comprising a pair of electrode terminals (147, 149) coupled to the battery cell and extending from the pouch, and
wherein the battery circuitry is coupled to the electrode terminals and is configured to monitor characteristics of the battery cell and to regulate charging and discharging of the battery cell based on the monitored characteristics of the battery cell.

2. The battery cell assembly and battery circuitry according to any preceding claim, wherein the battery circuitry comprises:
measurement circuitry (164) configured to measure the voltage on the conductive foil; and
logic circuitry (160) configured to determine whether the fault condition exists by comparing the voltage on the conductive foil to a predetermined voltage value.

3. The battery cell assembly and battery circuitry according to any preceding claim, wherein the pouch is heat sealed about the battery cell.

4. A method of monitoring fault conditions in a battery cell assembly including a battery cell and a pouch surrounding the battery cell, the pouch including an inner insulative jacket, an outer insulative jacket, and a conductive foil disposed between the inner and outer insulative jackets, a conductive lead (158) electrically coupled to the conductive foil and extending through the outer insulative jacket, the conductive lead configured to electrically couple to the battery circuitry, the battery cell assembly further comprising a pair of electrode terminals (147, 149) coupled to the battery cell and extending from the pouch, and wherein the battery circuitry is coupled to the electrode terminals, the method comprising:
measurement circuitry of the battery circuitry determining a voltage on the conductive foil;
logic circuitry of the battery circuitry comparing the voltage on the conductive foil to a predetermined voltage value; and
if the voltage of the conductive foil exceeds the predetermined voltage value, indicating a fault condition, wherein the method comprises
the battery circuitry monitoring characteristics of the battery cell and the battery circuitry regulating charging and discharging of the battery cell based on the monitored characteristics of the battery cell.

5. The method according to claim 4, further comprising converting the voltage on the conductive foil to a digital voltage value corresponding to the voltage on the conductive foil.

6. A battery assembly (118), comprising:
a battery pack (140), the battery pack including a plurality of battery cell assemblies (142), each battery cell assembly being according to claim 1:; and
wherein the battery circuitry, comprises:
measurement circuitry (164) electrically coupled to the conductive lead of each of the plurality of battery cell assemblies to measure a voltage of the conductive foil; and
logic circuitry (160) coupled to the measurement circuitry and configured to determine whether a fault condition exists based on the measured voltage of the conductive foil of each of the plurality of battery cell assemblies.

7. The battery assembly according to claim 6, wherein the logic circuitry determines whether a fault condition exists by comparing the measured voltage of each of the plurality of battery cell assemblies to a predetermined voltage.

8. The battery assembly according to any one of claims 6 to 7, further comprising a plurality of analog to digital converters (162), each analog to digital converter electrically coupled to a different one of the conductive leads and configured to convert an analog voltage on the conductive leads into a digital voltage value for output to the logic circuitry.

9. The battery assembly according to any one of claims 6 to 8, further comprising:
a multiplexer (166') coupled to each of the conductive leads and configured to alternatingly provide an analog voltage of each of the conductive leads; and
an analog to digital converter (162') configured to receive the analog voltage of each battery cell assembly from the multiplexer and to convert the analog voltage into a digital voltage value for output to the logic circuitry.

10. The battery cell assembly and battery circuitry according to claim 1, 2 or 3, the battery assembly according to claim 6, 7, 8 or 9, or method according to claim 6 or 7, wherein the battery cell is a lithium polymer battery cell.

11. The battery cell assembly and battery circuitry according to claim 2 or the battery assembly according to any one of claims 6 to 9 or the method according to claim 4 or claim 5, wherein the predetermined voltage value corresponds to zero volts.

12. The battery cell assembly and battery circuitry according to claim 2 or the battery assembly according to any one of claims 6 to 9 or the method according to claim 4 or claim 5, wherein the predetermined voltage value corresponds to a non-zero voltage.

## Patentansprüche

1. Batteriezellenanordnung (144) und eine Batterieschaltung (159), wobei die Batteriezellenanordnung umfasst:
eine Batteriezelle;
einen Beutel (146), der die Batteriezelle umschließt, wobei der Beutel umfasst:
eine innere isolierende Ummantelung (152);
eine äußere isolierende Ummantelung (154); und
eine leitfähige Folie (156), die zwischen der inneren und der äußeren isolierenden Ummantelung angeordnet ist;
einen leitfähigen Leiter (158), der elektrisch an die leitfähige Folie gekoppelt ist und sich durch die äußere isolierende Ummantelung erstreckt, wobei der leitfähige Leiter konfiguriert ist, um sich elektrisch mit der Batterieschaltung zu verbinden, und wobei die Batterieschaltung eine Spannung auf der leitfähigen Folie überwacht, um einen Fehlerzustand zu bestimmen,
wobei die Batteriezellenanordnung ferner ein Paar von Elektrodenanschlüssen (147, 149) umfasst, die mit der Batteriezelle verbunden sind und sich von dem Beutel aus erstrecken, und
wobei die Batterieschaltung mit den Elektrodenanschlüssen verbunden ist und konfiguriert ist, um Eigenschaften der Batteriezelle zu überwachen und um das Laden und Entladen der Batteriezelle auf der Grundlage der überwachten Eigenschaften der Batteriezelle zu regulieren.

2. Batteriezellenanordnung und eine Batterieschaltung nach einem vorhergehenden Anspruch, wobei die Batterieschaltung umfasst:
eine Messschaltung (164), die konfiguriert ist, um die Spannung auf der leitfähigen Folie zu messen; und
eine Logikschaltung (160), die konfiguriert ist, um zu bestimmen, ob der Fehlerzustand existiert, indem die Spannung auf der leitfähigen Folie mit einem vorgegebenen Spannungswert verglichen wird.

3. Batteriezellenanordnung und eine Batterieschaltung nach einem vorhergehenden Anspruch, wobei der Beutel um die Batteriezelle heißversiegelt ist.

4. Verfahren zum Überwachen der Fehlerzustände in einer Batteriezellenanordnung, die eine Batteriezelle und einen Beutel, der die Batteriezelle umschließt, enthält, wobei der Beutel eine innere isolierende Ummantelung, eine äußere isolierende Ummantelung und eine leitfähige Folie, die zwischen der inneren und der äußeren isolierenden Ummantelung angeordnet ist, enthält, wobei der leitfähige Leiter (158) elektrisch an die leitfähige Folie gekoppelt ist und sich durch die äußere isolierende Ummantelung erstreckt, wobei der leitfähige Leiter konfiguriert ist, um sich elektrisch mit der Batterieschaltung zu verbinden, wobei die Batteriezellenanordnung ferner ein Paar von Elektrodenanschlüssen (147, 149) umfasst, die mit der Batteriezelle verbunden sind und sich von dem Beutel aus erstrecken, und wobei die Batterieschaltung mit den Elektrodenanschlüssen verbunden ist, wobei das Verfahren ferner umfasst;
eine Messschaltung der Batterieschaltung, die eine Spannung auf der leitfähigen Folie bestimmt;
eine Logikschaltung der Batterieschaltung, die die Spannung auf der leitfähigen Folie mit einem vorgegebenen Spannungswert vergleicht; und
wenn die Spannung der leitfähigen Folie den vorgegebenen Spannungswert übersteigt, dann Angeben eines Fehlerzustands, wobei das Verfahren umfasst:
durch die Batterieschaltung Überwachen der Eigenschaften der Batteriezelle zu und durch die Batterieschaltung Regulieren des Ladens und Entladens der Batteriezelle auf der Grundlage der überwachten Eigenschaften der Batteriezelle.

5. Verfahren nach Anspruch 4, das ferner ein Umsetzen der Spannung auf der leitfähigen Folie in einen digitalen Spannungswert umfasst, der der Spannung auf der leitfähigen Folie entspricht.

6. Batterieanordnung (118), die umfasst:
ein Batteriepaket (140), wobei das Batteriepaket mehrere Batteriezellenanordnungen (142) enthält, wobei jede Batteriezellenanordnung eine solche nach Anspruch 1 ist; und
wobei die Batterieschaltung umfasst:
eine Messschaltung (164), die mit dem leitfähigen Leiter jeder der mehreren Batteriezellenanordnungen elektrisch verbunden ist, um eine Spannung der leitfähigen Folie zu messen; und
eine Logikschaltung (160), die mit der Messschaltung verbunden ist und konfiguriert ist, um auf der Grundlage der gemessenen Spannung der leitfähigen Folie jeder der mehreren Batteriezellenanordnungen zu bestimmen, ob ein Fehlerzustand existiert.

7. Batterieanordnung nach Anspruch 6, wobei die Logikschaltung bestimmt, ob ein Fehlerzustand existiert, indem die gemessene Spannung jeder der mehreren Batteriezellenanordnungen mit einer vorgegebenen Spannung verglichen wird.

8. Batterieanordnung nach einem der Ansprüche 6 bis 7, die ferner mehrere Analog-/Digital-Umsetzer (162) umfasst, wobei jeder Analog-/Digital-Umsetzer elektrisch mit einem anderen von den leitfähigen Leitern verbunden ist und konfiguriert ist, um eine analoge Spannung auf den leitfähigen Leitern in einen digitalen Spannungswert für eine Ausgabe an der Logikschaltung umzusetzen.

9. Batterieanordnung nach einem der Ansprüche 6 bis 8, die ferner umfasst:
einen Multiplexer (166'), der mit jedem der leitfähigen Leiter verbunden ist und konfiguriert ist, um abwechselnd eine analoge Spannung von jedem der leitfähigen Leiter bereitzustellen; und
einen Analog-/Digital-Umsetzer (162'), der konfiguriert ist, um die analoge Spannung jeder Batteriezellenanordnung von dem Multiplexer zu empfangen und um die analoge Spannung in einen digitalen Spannungswert für eine Ausgabe an der Logikschaltung umzusetzen.

10. Batteriezellenanordnung und Batterieschaltung nach Anspruch 1, 2 oder 3, Batterieanordnung nach Anspruch 6, 7, 8 oder 9 oder Verfahren nach Anspruch 6 oder 7, wobei die Batteriezelle eine Lithium-Polymer-Batteriezelle ist.

11. Batteriezellenanordnung und Batterieschaltung nach Anspruch 2 oder die Batterieanordnung nach einem der Ansprüche 6 bis 9 oder das Verfahren nach Anspruch 4 oder 5, wobei der vorgegebene Spannungswert Null Volt entspricht.

12. Batteriezellenanordnung und Batterieschaltung nach Anspruch 2 oder die Batterieanordnung nach einem der Ansprüche 6 bis 9 oder das Verfahren nach Anspruch 4 oder 5, wobei der vorgegebene Spannungswert einer Nicht-Null Spannung entspricht.

## Revendications

1. Ensemble d'élément de batterie (144) et circuits de batterie (159), l'ensemble d'élément de batterie comprenant :
un élément de batterie ;
un sac (146) enserrant l'élément de batterie, le sac comprenant :
une chemise isolante interne (152) ;
une chemise isolante externe (154) ; et
un film conducteur (156) disposé entre les chemises isolantes interne et externe ;
un fil conducteur (158) couplé électriquement au film conducteur et s'étendant à travers la chemise isolante externe, le fil conducteur étant configuré pour se coupler électriquement aux circuits de batterie, les circuits de batterie étant destinés à la surveillance d'une tension sur le film conducteur pour déterminer un état de défaut,
l'ensemble d'élément de batterie comprenant en outre une paire de bornes d'électrodes (147, 149) couplées à l'élément de batterie et s'étendant depuis le sac, et
dans lesquels les circuits de batterie sont couplés aux bornes d'électrodes et configurés pour surveiller les caractéristiques de l'élément de batterie et réguler le chargement et le déchargement de l'élément de batterie sur la base des caractéristiques surveillées de l'élément de batterie.

2. Ensemble d'élément de batterie et circuits de batterie selon l'une quelconque des revendications précédentes, dans lesquels les circuits de batterie comprennent :
des circuits de mesure (164) configurés pour mesurer la tension sur le film conducteur ; et
des circuits logiques (160) configurés pour déterminer si l'état de défaut existe en comparant la tension sur le film conducteur avec une valeur de tension prédéterminée.

3. Ensemble d'élément de batterie et circuits de batterie selon l'une quelconque des revendications précédentes, dans lesquels le sac est scellé à chaud autour de l'élément de batterie.

4. Procédé de surveillance d'état de défauts dans un ensemble d'élément de batterie comprenant un élément de batterie et un sac entourant l'élément de batterie, la sac comprenant une chemise isolante interne, une chemise isolante externe et un film conducteur disposé entre les chemises isolantes interne et externe, un fil conducteur (158) couplé électriquement au film conducteur et s'étendant à travers la chemise isolante externe, le fil conducteur étant configuré pour se coupler électriquement aux circuits de batterie, l'ensemble d'élément de batterie comprenant en outre une paire de bornes d'électrodes (147, 149) couplées à l'élément de batterie et s'étendant du sac, et dans lequel les circuits de batterie sont couplés aux bornes d'électrodes, le procédé comprenant :
la détermination par les circuits de mesure des circuits de batterie d'une tension sur le film conducteur ;
la comparaison par les circuits logiques des circuits de batterie de la tension sur le film conducteur à une valeur de tension prédéterminée ; et,
si la tension du film conducteur dépasse la valeur de tension prédéterminée indiquant un état de défaut, dans lequel le procédé comprend :
la surveillance par les circuits de batterie des caractéristiques de l'élément de batterie et la régulation par les circuits de batterie du chargement et du déchargement de l'élément de batterie sur la base des caractéristiques surveillées de l'élément de batterie.

5. Procédé selon la revendication 4, comprenant en outre la conversion de la tension sur le film conducteur en une valeur de tension numérique correspondant à la tension sur le film conducteur.

6. Ensemble de batteries (118), comprenant :
un bloc de batteries (140), le bloc de batteries comprenant une pluralité d'ensembles d'éléments de batterie (142), chaque ensemble d'éléments de batterie étant conforme à la revendication 1 ; et
dans lequel les circuits de batterie comprennent :
ces circuits de mesure (164) couplés électriquement au fil conducteur de chacun de la pluralité d'ensembles d'éléments de batterie pour mesurer une tension du film conducteur ; et
des circuits logiques (160) couplés aux circuits de mesure et configurés pour déterminer si un état de défaut existe sur la base de la tension mesurée du film conducteur de chacun de la pluralité d'ensembles d'éléments de batteries.

7. Ensemble de batteries selon la revendication 6, dans lequel les circuits logiques déterminent si un état de défaut existe en comparant la tension mesurée de chacun de la pluralité d'ensembles d'éléments de batteries à une tension prédéterminée.

8. Ensemble de batteries selon l'une quelconque des revendications 6 à 7, comprenant en outre une pluralité de convertisseurs analogiques-numériques (162), chaque convertisseur analogique-numérique étant couplé électriquement avec l'un différent des fils conducteurs et configuré pour convertir une tension analogique sur les fils conducteurs en une valeur de tension numérique pour délivrer aux circuits logiques.

9. Ensemble de batteries selon l'une quelconque des revendications 6 à 8, comprenant en outre :
un multiplexeur (166') couplé à chacun des fils conducteurs et configuré pour fournir en alternance une tension analogique de chacun des fils conducteurs ; et
un convertisseur analogique-numérique (162') configuré pour recevoir la tension analogique de chaque ensemble d'élément de batterie du multiplexeur et convertir la tension analogique en une valeur de tension numérique pour délivrer aux circuits logiques.

10. Ensemble d'élément de batterie et circuits de batterie selon la revendication 1, 2 ou 3, ensemble de batteries selon la revendication 6, 7, 8 ou 9 ou procédé selon la revendication 6 ou 7, dans lequel l'élément de batterie est un élément de batterie de polymère au lithium.

11. Ensemble d'élément de batterie et circuits de batterie selon la revendication 2, ou ensemble de batteries selon l'une quelconque des revendications 6 à 9 ou procédé selon la revendication 4 ou 5, dans lequel la valeur de tension prédéterminée correspond à zéro volt.

12. Ensemble d'élément de batterie et circuits de batterie selon la revendication 2, ou ensemble de batteries selon l'une quelconque des revendications 6 à 9 ou procédé selon la revendication 4 ou 5, dans lequel la valeur de tension prédéterminée correspond à une tension non nulle.
